Europäisches Patentamt

European Patent Office

Office européen des brevets

(19)

(11) Veröffentlichungsnummer : **0 017 979**
**B1**

(12) EUROPÄISCHE PATENTSCHRIFT

(45) Veröffentlichungstag der Patentschrift :
26.09.84

(21) Anmeldenummer : 80102045.4

(22) Anmeldetag : 16.04.80

(51) Int. Cl.³ : **H 01 C   1/16, H 01 C   7/00,**
**H 01 C 17/24, H 05 K   1/16**

(54) Elektrisches Netzwerk und Herstellungsverfahren.

(30) Priorität : 23.04.79 DE 2916329

(43) Veröffentlichungstag der Anmeldung :
29.10.80 Patentblatt 80/22

(45) Bekanntmachung des Hinweises auf die Patenterteilung : 26.09.84 Patentblatt 84/39

(84) Benannte Vertragsstaaten :
FR GB IT

(56) Entgegenhaltungen :
DE-A- 2 029 235
DE-A- 2 641 310
DE-A- 2 655 841
DE-A- 2 820 153
DE-B- 1 243 254
FR-A- 2 024 557
FR-A- 2 084 834
GB-A- 1 477 572
US-A- 3 873 756

(73) Patentinhaber : Siemens Aktiengesellschaft
Berlin und München Wittelsbacherplatz 2
D-8000 München 2 (DE)

(72) Erfinder : Utner, Ferdinand
Roter Brachweg 99
D-8400 Regensburg (DE)
Erfinder : Vetter, Harald, Ing. grad.
Weinberg 7
D-8400 Regensburg (DE)
Erfinder : Nutz, Ludwig
Meeboldstrasse 45
D-7920 Heidenheim (DE)

**Beschreibung**

Die vorliegende Erfindung betrifft ein elektrisches Netzwerk, welches zumindest Widerstandsschichten und mit diesen stoffschlüssig verbundene Leiterbahnen und Anschlußelemente enthält, wobei die Widerstandsschichten, Leiterbahnen und Anschlußelemente mit einer biegsamen Trägerfolie stoffschlüssig verbunden sind.

Ein derartiges Netzwerk ist aus der DE-A 26 41 310 bekannt. Dort dient als Träger eine Kunststoffolie, auf die beidseitig Metallfolien heiß aufgepreßt sind, wobei zumindest eine der Metallfolien aus mehreren Schichten besteht, aus denen Widerstände und Leiterbahnen herausgearbeitet sind.

Derartige Netzwerke lassen sich nur mit relativ breiten Widerstandsschichten und Leiterbahnen herstellen, da die Kunststoffolien bei der Erzeugung der Strukturen erheblichen Beanspruchungen ausgesetzt werden, welche zu einer mechanischen Zerstörung von schmalen Metallschichten auf der Kunststoffolie führen. Dies gilt selbst bei einer Versteifung der bekannten Netzwerke durch Aufkleben eines zusätzlichen Trägers, beispielsweise aus Hartpapier.

Aus der DE-B 12 43 254 ist ein Trägerkörper für Mikroschaltkreise bekannt, der aus einer Metallplatte besteht, deren Oberfläche durch einen Oxidationsprozeß mit einer isolierenden Zwischenschicht versehen ist. Durch diese Ausgestaltung wird die durch die Verlustleistung entstehende Wärme besser abgeführt, so daß eine weitere Miniaturisierung der bekannten Mikroschaltungen ermöglicht wird. Eine Serienfertigung im Bandverfahren ist jedoch bei dieser Ausgestaltung nicht möglich.

Die Aufgabe, die der vorliegenden Erfindung zugrundeliegt, besteht bei einem elektrischen Netzwerk der eingangs beschriebenen Art darin, daß noch feinere Strukturen von Widerstandsschichten und Leiterbahnen auf einer Trägerfolie erzeugt werden und daß eine Serienfertigung im Bandverfahren mit hoher Ausbeute ermöglicht wird.

Diese Aufgabe wird erfindungsgemäß dadurch gelöst, daß die Trägerfolie eine Metallfolie ist, daß die Trägerfolie zumindest teilweise aus lötfähigem Metall besteht, und daß auf die Trägerfolie eine auf ihren beiden Oberflächen mit Metallschichten zumindest stoffschlüssig verbundene, bis 200 °C temperaturfeste Isolierstoffschicht aufgelötet ist, deren eine, nach außen weisende Metallschicht ein elektrisches Netzwerk darstellt.

Dieser Aufbau besitzt eine hohe Zuggestigkeit, so daß die mechanischen Beanspruchungen bei der Fertigung wie auch beim Einsatz der Schaltungen nicht zu einer Zerstörung von schmalen Widerstandsschichten oder Leiterbahnen führen können. Ferner können keine Fehler in der Schaltung durch das Aushärten eines Klebers auftreten. Eine besonders rationale Herstellung dieser Ausführungsform ist ermöglicht, da keine Härtestrecken oder Nachhärteprozesse notwendig sind. Ein besonders guter Wärmekontakt zwischen Folie und Träger ermöglicht eine hohe thermische Belastung der Leitungen des Netzwerkes. Bei der Herstellung tritt keine Verschmutzung der Folie und der Anlagen durch Harz auf. Die beschriebene Art der Verbindung mittels Löten wird im folgenden als « Lötkaschierung » bezeichnet.

Eine derartige Lötkaschierung ist vorteilhaft ausgeführt, indem auf einer ersten Seite der Kunststoffschicht die Schichten des Netzwerkes aufgebracht sind und die zweite Seite von einer Schicht des lötfähigen Metalls vollständig bedeckt ist und in dem diese Schicht aus lötfähigem Metall mit dem Träger ganzflächig verlötet ist.

Sollen eng nebeneinanderliegende Anschlußelemente angebracht werden, so ist es vorteilhaft, wenn zunächst ein Muster einer Widerstandsschicht aus Nickel-Chrom und darüber ein Muster einer Kupferschicht aufgebracht ist, wenn Anschlußklammern im Bereich von Anschlußleitern des Netzwerkes über die Kanten des entstandenen Schichtpaketes geschoben sind und wenn das Netzwerk mit Kunststoff umhüllt ist. Die Anschlußklammern können relativ schmal ausgebildet sein, ihre Materialstärke ist frei wählbar. Diese Lösung ist vorteilhaft, da die Anschlußklammern allseitig lösbar sind. Die Kunststoffumhüllung gewährleistet neben der für die Beanspruchung bis zum Einbau erforderlichen Unempfindlichkeit gegen Berührung die für die Anwendung notwendige mechanisch feste Verbindung der Klammern mit dem Netzwerk. Die Anschlußklammern sind vorteilhaft auf die Anschlußleiter aufgelötet.

Eine einfache Aufbauform und eine besonders sichere Kontaktierung ist gegeben, indem an die Trägerfolie Stecker angeformt sind, indem zumindest ein Teil der an die Trägerfolie angeformten Stecker von den spannungsführenden Teilen des Netzwerkes isoliert ist und indem Kontaktflächen durch eine Isolierstoffschicht von den Steckern getrennt auf diesen angeordnet sind. Die Isolierstoffschicht kann in Form einer Folie vor dem Ausstanzen der Stecker auf die beiden Seiten der Metallfolie aufgeklebt sein. In diesem Fall empfiehlt es sich, daß die Kontaktflächen nicht bis zu den Kanten der Stecker reichen. Eine noch bessere Kontaktierung der Kontaktflächen wird erreicht, indem die Stecker allseitig von Kunststoff umhüllt sind und indem die Kontaktflächen um die Stecker herumreichen.

Als Trägermaterial eignet sich insbesondere Aluminiumfolie oder für besonders hohe Anforderungen an die mechanische Stabilität Stahlblechfolie.

Ein vorteilhaftes Verfahren zur Herstellung eines erfindungsgemäßen elektrischen Netzwerkes bei dem die Kaschier- und Ätzvorgänge im Bandverfahren durchgeführt wurden, ist durch die folgende Reihenfolge von Verfahrensschritten gekennzeichnet:

a) Beschichtung der über 200 °C temperaturbeständigen Isolierstoffschicht auf der einen Seite mit den zur Ausbildung des elektrischen Netzwerkes bestimmten Metallschichten und auf der anderen Seite mit einer weiteren Metallschicht,

b) Verlötung der Isolierstoffschicht mit der Trägerfolie,

c) Ätzen, insbesondere selektives Ätzen, der Schichten des Netzwerkes, wobei die Trägerfolie vor dem Ätzen mit einer die Ätzflüssigkeit abhaltenden Schutzschicht überzogen wurde,

d) Stabilisieren der Widerstandsschichten durch Tempern bei zumindest etwa 200 °C,

e) Umhüllen des Netzwerkes mit Kunststoff.

Bei diesem Verfahren sind die empfindlichen dünnen Widerstandsschichten, die vorzugsweise aus Chrom-Nickel bestehen, während des Kaschierprozesses durch die für die Leiterbahnen vorgesehene Schicht, die relativ dick ausgebildet ist und vorzugsweise aus Kupfer besteht, mechanisch geschützt. Diese Schichten werden beispielsweise dadurch hergestellt, daß auf eine Kupferfolie die Widerstandsschichten aus Chrom-Nickel aufgedampft werden. Diese Schichtenfolge wird dann auf die Isolierstoffschicht aufkaschiert. Beim Ätzvorgang sind diese Schichten bereits mit der Trägerfolie stoffschlüssig verbunden. Dies ist wesentlich, da in die für die Leiterbahnen vorgesehene Schicht nun Muster hineingeätzt werden ; sie dient also nicht mehr als Schutz, sie bildet im Gegenteil nun Bereiche mit scharfen Kanten, welche aufgrund der relativen Dicke dieser Schicht geeignet sind, bei mechanischer Beanspruchung die Widerstandsschicht zu beschädigen oder zu zerstören. Diese Beschädigung oder Zerstörung der Widerstandsschicht wird beim vorgeschlagenen Verfahren durch die versteifende Wirkung der Trägerfolie vermieden.

Unter einem selektiven Ätzen wird hier verstanden, daß beispielsweise unter Verwendung einer Schicht aus Kupfer und einer Widerstandsschicht aus Chrom-Nickel zunächst in die Kupferschicht Muster hineingeätzt werden, die den späteren isolierenden Bereichen entsprechen.

Daraufhin werden die Widerstandsschichten unter der Kupferschicht weggeätzt, nicht aber die noch vorhandenen Teile der Kupferschicht. Daraufhin werden die noch vorhandenen Teile der Kupferschicht bis auf die in der Schaltung notwendigen Leiterbahnen bzw. Kontaktflächen weggeätzt, nicht aber die darunterliegende Widerstandsschicht. Während dieser Ätzvorgänge muß die Trägerfolie von einer die Ätzflüssigkeit abhaltenden Schutzschicht überzogen sein, damit das Ätzbad nicht schnell unwirksam wird. Sofern eine Kontaktierung durch Kammern vorgesehen ist, muß diese Schutzschicht bis über 200 °C temperaturbeständig sein, damit sie beim folgenden Stabilisieren der Widerstandsschicht nicht zerstört wird. Das könnte zu Kurzschlüssen zwischen den Klammern führen. Sofern eine Kontaktierung über angeformte Stecker erfolgt, kann zumindest im Bereich außerhalb der Stecker auf der dem Netzwerk abgewandten Seite der Trägerfolie eine weniger temperaturbeständige Schutzschicht verwendet werden. Eine Zerstörung der Schutzschicht beim Stabilisieren beeinträchtigt hier die Qualität des Netzwerkes nicht.

Das Umhüllen des Netzwerkes erfolgt vorteilhaft durch Aufstäuben und Anschmelzen von Kunststoff, z. B. im elektrischen Feld, also durch das bekannte Wirbelsintern. Dabei wird vorteilhaft der aufgestäubte Kunststoff von den Kontaktflächen auf den Steckern vor dem Glattschmelzen des Kunststoffes entfernt.

Sollen Kontaktklammern verwendet werden, so werden diese vor dem Umhüllen angebracht. Die nicht zu umhüllenden Teile werden zweckmäßig durch Klebestreifen geschützt.

Für einen Funktionsabgleich nach der Umhüllung ist es vorteilhaft, wenn als Umhüllung zumindest teilweise, nämlich mindestens im Bereich der abzugleichenden Bauelemente, ein für Laserlicht durchlässiger Kunststoff verwendet wird und wenn das Netzwerk nach dem Umhüllen mittels eines Lasers abgeglichen wird. Dadurch werden Einflüsse der Umhüllung auf den Abgleich kompensiert.

Ein besonders platzsparender Aufbau ist dadurch gegeben, daß die mit der Widerstandsschicht beschichtete Metallfolie, die auch als Netzwerkfolie bezeichnet wird, um die Trägerfolie herumgeklappt und beidseitig mit der Trägerfolie verlötet wird. Ein besonders kleiner Aufbau mit einer großen Zahl von Steckern ist gegeben, indem an die Trägerfolie beidseitig Stecker angeformt werden, indem das Netzwerk gebogen wird und indem die Stecker in zueinander parallele Richtungen gebogen werden. Diese Ausführungsform ist insbesondere bei vorgegebenem, engem Rastermaß vorteilhaft, wenn in der Höhe Raum zur Verfügung steht, der beispielsweise durch die Höhe auf einer Schaltungsplatine benachbarter Bauelemente vorgegeben ist.

Als Material für die über 200 °C temperaturbeständige Isolierstoffschicht eignet sich insbesondere Polyimid.

Die mit der Widerstandsschicht beschichtete Kupferfolie soll eine Mindeststärke von 3 μm besitzen, um die nötige Festigkeit aufzuweisen.

Für die Lötkaschierung eignet sich besonders ggf. verzinntes Kupferblech oder ein verzinntes Stahlblech.

Zur Umhüllung wird vorteilhaft ein für Laserlicht durchlässiges Harz verwendet, so daß ein Funktionsabgleich mittels eines Lasers nach der Umhüllung problemlos möglich ist.

Aufgrund der guten Wärmeableitung der vorgeschlagenen Trägerfolie aus Metall können die Chrom-Nickel-Schichten höher thermisch belastet werden als nach dem Stand der Technik. Dies ergibt eine Verkleinerung der Netzwerke und damit einen kleineren Aufwand. Außerdem sind die Streuungen der Widerstandswerte der vorgeschlagenen Widerstandsnetzwerke deutlich enger als von Netzwerken gemäß dem Stand der Technik.

Die Erfindung wird anhand von 2 Figuren näher erläutert.

Figur 1 zeigt die Draufsicht auf ein Netzwerk mit angeformten Steckern ohne Umhüllung und

Figur 2 zeigt ein Netzwerk, bei dem eine Netzwerkfolie um die Trägerfolie herumgeklappt und durch Lötkaschierung mit dieser verbunden ist.

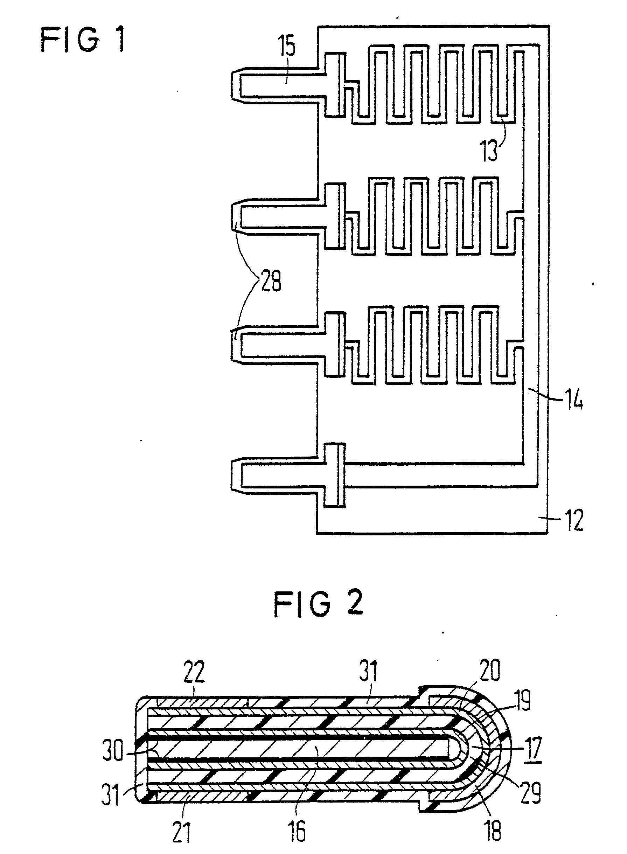

In Fig. 1 ist die Draufsicht auf ein Netzwerk gemäß der Erfindung dargestellt. An eine Trägerfolie aus Metall, auf die eine bis mindestens 200 °C temperaturbeständige Kunststoffolie 12 aufkaschiert ist, sind Stecker 28 angeformt. Mit der Kunststoffolie 12 sind eine gemustere Widerstandsschicht 13 und über dieser eine gemusterte Metallschicht stoffschlüssig verbunden. Die gemusterte Metallschicht besteht vorzugsweise aus Kupfer und bildet eine Anschlußleitung 14 und Kontaktflächen 15. Mit Ausnahme der Kontaktflächen 15 wird das beschriebene Netzwerk allseitig durch eine Kunststoffschicht umhüllt.

Figur 2 zeigt eine weitere Ausführungsform, bei der auf eine Trägerfolie 16 aus einem lötfähigen Metall, beispielsweise aus Kupfer oder verzinntem Eisen, eine Netzwerkfolie 17 aufgelötet, um die Trägerfolie 16 herumgeklappt und auf der Rückseite nochmals mit der Trägerfolie 16 verlötet ist. Die Netzwerkfolie 17 besteht aus einer hochtemperaturfesten Kunststoffolie 29, die auf einer Seite mit einer lötfähigen Metallschicht 19 ganzflächig beschichtet ist, während sich auf der anderen Seite eine gemusterte Widerstandsschicht 20 und eine darüber angeordnete gemusterte Metallschicht 18 befindet.

Die Trägerfolie 16 ist beidseitig mit Zinnschichten 30 ganzflächig bedeckt, so daß für das Kaschieren eine Wärmebehandlung ohne Zufuhr von weiterem Lot genügt. Anstelle der oder zusätzlich zu der Trägerfolie 16 kann auch die lötfähige Metallschicht 19 mit einer Zinnschicht ganzflächig überzogen sein. Das Netzwerk ist durch eine Kunststoffumhüllung 31 geschützt, welche das Netzwerk mit Ausnahme der Kontaktflächen 21 und 22 vollständig umhüllt. Genauso kann eine Lötkaschierung der geschilderten Art nur auf einer Seite des lötfähigen Metallträgers erfolgen.

**Ansprüche**

1. Elektrisches Netzwerk, welches zumindest Widerstandsschichten (13, 20) und mit diesen stoffschlüssig verbundene Leiterbahnen und Anschlußleitungen (14, 15, 18, 21, 22) enthält, wobei die Widerstandsschichten und Leiterbahnen und Anschlußelemente mit einer biegsamen Trägerfolie (16) stoffschlüssig verbunden sind, dadurch gekennzeichnet, daß die Trägerfolie (16) eine Metallfolie ist, daß die Trägerfolie (16) zumindest teilweise aus lötfähigem Metall besteht und daß auf die Trägerfolie (16) eine auf ihren beiden Oberflächen mit Metallschichten stoffschlüssig verbundene, zumindest bis 200 °C temperaturfeste Isolierstoffschicht (12, 29) aufgelötet ist, deren eine, nach außen weisende Metallschicht ein elektrisches Netzwerk darstellt.

2. Elektrisches Netzwerk nach Anspruch 1, dadurch gekennzeichnet, daß auf eine Seite der Isolierstoffschicht (12, 29) zunächst ein Muster einer Widerstandsschicht (13, 20) aus Nickel-Chrom und darüber ein Muster einer Kupferschicht aufgebracht ist, daß Anschlußklammern im Bereich von Anschlußleitern des Netzwerkes über die Kanten des entstandenen Schichtpaketes geschoben sind und daß das Netzwerk mit Kunststoff (31) umhüllt.

3. Elektrisches Netzwerk nach Anspruch 1, dadurch gekennzeichnet, daß die Anschlußklammern auf die Anschlußleiter aufgelötet sind.

4. Elektrisches Netzwerk nach Anspruch 1, dadurch gekennzeichnet, daß an die Trägerfolie Stecker (28) angeformt sind, daß zumindest ein Teil der an die Trägerfolie angeformten Stecker von den spannungsführenden Teilen des Netzwerkes isoliert ist und daß Kontaktflächen (15) durch eine Isolierstoffschicht von den Steckern getrennt auf diesen angeordnet sind.

5. Elektrisches Netzwerk nach Anspruch 4, dadurch gekennzeichnet, daß die Kontaktflächen (15) nicht bis zur Kante des Steckers reichen.

6. Elektrisches Netzwerk nach Anspruch 4, dadurch gekennzeichnet, daß die Stecker allseitig von Kunststoff umhüllt sind und daß die Kontaktflächen um die Kanten der Stecker herumreichen.

7. Elektrisches Netzwerk nach einem der Ansprüche 1 bis 6, dadurch gekennzeichnet, daß als Trägerfolie eine Aluminiumfolie verwendet wird.

8. Elektrisches Netzwerk nach einem der Ansprüche 1 bis 6, dadurch gekennzeichnet, daß als Trägerfolie eine Stahlblechfolie verwendet wird.

9. Verfahren zur Herstellung eines elektrischen Netzwerkes nach einem der Ansprüche 1 bis 8, bei dem die Kaschier- und Ätzvorgänge im Bandverfahren durchgeführt werden, gekennzeichnet durch die folgende Reihenfolge der Verfahrensschritte:

a) Beschichtung der über 200 °C temperaturbeständigen Isolierstoffschicht auf der einen Seite mit den zur Ausbildung des elektrischen Netzwerkes bestimmten Metallschichten und auf der anderen Seite mit einer weiteren Metallschicht,

b) Verlötung der Isolierstoffschicht mit der Trägerfolie,

c) Ätzen, insbesondere selektives Ätzen, der Schichten des Netzwerks, wobei die Trägerfolie vor dem Ätzen mit einer die Ätzflüssigkeit abhaltenden Schutzschicht überzogen wurde,

d) Stabilisierung der Widerstandsschichten durch Temperm bei zumindest etwa 200 °C,

e) Umhüllung des Netzwerkes mit Kunststoff.

10. Verfahren nach Anspruch 9, dadurch gekennzeichnet, daß vor dem Umhüllen Kontaktklammern angebracht werden.

11. Verfahren nach einem der Ansprüche 9 oder 10, dadurch gekennzeichnet, daß als Umhüllung zumindest teilweise ein für Laserlicht durchlässiger Kunststoff verwendet wird und daß das Netzwerk nach dem Umhüllen mittels eines Lasers abgeglichen wird.

12. Verfahren nach Anspruch 9, dadurch gekennzeichnet, daß die Netzwerkfolie um die Trägerfolie herumgeklappt und beidseitig mit der Trägerfolie verlötet wird.

13. Verfahren nach einem der Ansprüche 9 bis 12, dadurch gekennzeichnet, daß an die Trägerfolie beidseitig Stecker angeformt werden, daß das Netzwerk gebogen wird und daß die Stecker in zueinander parallele Richtung gebogen werden.

## Claims

1. An electrical network which comprises at least resistance layers (13, 20) and conductor paths and connecting lines (14, 15, 18, 21, 22) which are connected to said resistance layers in materially bonded manner, the resistance layers and conductor paths and connection elements being connected in materially bonded manner to a flexible carrier foil (16), characterised in that the carrier foil (16) is a metal foil ; that the carrier foil (16) consists at least partially of solderable metal ; and that an insulating layer (12, 29), which is connected at its two faces to metal layers so as to be materially bonded thereto and is resistant to heat at least up to 200 °C, is soldered onto the carrier foil (16), one outwardly directed metal layer thereof forming an electrical network.

2. An electrical network according to Claim 1, characterised in that a pattern of a resistance layer (13, 20) consisting of nickel-chromium is first applied on to one side of the insulating layer (12, 29) and over that a pattern of a copper layer ; that in the region of connecting lines of the network, connection terminals are pushed over the edges of the formed layer assembly ; and that the network is encased with synthetic resin (31).

3. An electrical network according to Claim 1, characterised in that the connection terminals are soldered on to the connecting lines.

4. An electrical network according to Claim 1, characterised in that plugs (28) are attached to the carrier foil ; that at least a portion of the plugs attached to the carrier foil is insulated from the voltage-carrying components of the network ; and that contact surfaces (15) are separated from the plugs by an insulating layer arranged on said plugs.

5. An electrical network according to Claim 4, characterised in that the contact surfaces (15) do not extend to the edge of the plug.

6. An electrical network according to Claim 4, characterised in that the plugs are enveloped with synthetic resin on all sides ; and that the contact surfaces extend around the edges of the plugs.

7. An electrical network according to one of Claims 1 to 6, characterised in that an aluminium foil is used as carrier foil.

8. An electrical network according to one of Claims 1 to 6, characterised in that a steel sheet is used as carrier foil.

9. A method of manufacturing an electrical network according to one of Claims 1 to 8, in which the coating and etching steps are carried out by the belt method, characterised by the following sequence of process steps :

a) coating of the insulating layer which is resistant to heat above 200 °C, with the metal layers, which are intended for forming the electrical network on the one side, and with a further metal layer on the other side ;

b) soldering of the insulating layer to the carrier foil ;

c) etching, in particular selective etching, of the layers of the network, where, prior to the etching, the carrier foil has been coated with a protective layer which holds off the etching liquid ;

d) stabilisation of the resistance layers by annealing at at least about 200 °C,

e) encasing of the network with synthetic resin.

10. A method according to Claim 9, characterised in that, prior to the encasing, contact terminals are installed.

11. A method according to one of Claims 9 or 10, characterised in that a synthetic resin which is at least partially permeable to laser light is used as casing ; and that after the encasement, the network is adjusted by means of a laser.

12. A method according to Claim 9, characterised in that the network foil is folded around the carrier foil and is soldered to the carrier foil on both sides.

13. A method according to one of Claims 9 to 12, characterised in that plugs are attached to the carrier foil on both sides ; that the network is bent ; and that the plugs are bent in a mutually parallel direction.

## Revendications

1. Réseau électrique qui comporte au moins des couches résistives (13, 20), des pistes conductrices et des conducteurs de raccordement (14, 15, 18, 21, 22) par liaison entre matériaux avec celle-ci, les couches résistives et les pistes conductrices et les éléments de raccordement étant reliés à une feuille de support flexible (16) par liaison entre matériaux, caractérisé par le fait que la feuille de support (16) est une feuille métallique, que la feuille de support (16) est constituée au moins en partie avec un métal soudable et que sur la feuille de support (16) est soudée une couche d'une substance isolante (19, 20) résistant à des températures allant au moins jusqu'à 200 °C et dont les deux faces sont reliées par une liaison entre matériaux, à des couches métalliques dont une, dirigée vers l'extérieur, représente un réseau électrique.

2. Réseau électrique selon la revendication 1, caractérisé par le fait que sur un côté de la couche isolante (12, 29), est d'abord déposé un modèle d'une couche résistive (13, 20) en nickel-chrome et sur celle-ci un modèle d'une couche de cuivre, que des agrafes de raccordement sont glissées, dans la zone des conducteurs de raccordement du réseau, sur les bords du paquet stratifié, et que le réseau est enrobé de matière plastique (31).

3. Réseau électrique selon la revendication 1, caractérisé par le fait que les agrafes de raccordement sont soudées sur les conducteurs de raccordement.

4. Réseau électrique selon la revendication 1, caractérisé par le fait que sur la feuille de support sont conformées des fiches (28), qu'au moins une partie des fiches conformées sur la feuille de support est isolée par rapport aux parties du réseau qui sont sous tension, et que des surfaces de contact (15) sont disposées sur les fiches dont elles sont séparées par une couche d'une substance isolante.

5. Réseau électrique selon la revendication 4, caractérisé par le fait que les surfaces de contact (15) ne s'étendent pas jusqu'au bord de la fiche.

6. Réseau électrique selon la revendication 4, caractérisé par le fait que les fiches sont enrobées de toutes parts avec une matière plastique, et que les surfaces de contact s'étendent autour des bords des fiches.

7. Réseau électrique selon l'une des revendications 1 à 6, caractérisé par le fait que l'on utilise, comme feuille de support, une feuille d'aluminium.

8. Réseau électrique selon l'une des revendications 1 à 6, caractérisé par le fait que l'on utilise, comme feuille de support, une feuille de tôle d'acier.

9. Procédé pour la fabrication d'un réseau électrique selon l'une des revendications 1 à 8, dans lequel les opérations de placage et d'attaque sont réalisées en continu, caractérisé par la succession suivante des phases opératoires :

a) revêtement de la couche de substance isolante résistant à des températures allant au-delà de 200 °C, et sur un de ses côtés, avec les couches métalliques qui sont destinées à la formation du réseau électrique, et sur son autre côté, avec une seconde couche métallique,

b) soudage de la couche de substance isolante avec la feuille de support,

c) attaque, en particulier attaque sélective, des couches du réseau, la feuille de support étant, avant l'attaque, revêtue d'une couche de protection retenant le liquide d'attaque,

d) stabilisation des couches résistives par traitement thermique à au moins environ 200 °C,

e) enrobage du réseau avec une matière plastique.

10. Procédé selon la revendication 9, caractérisé par le fait qu'avant l'enrobage on fixe des agrafes de contact.

11. Procédé selon l'une des revendications 9 ou 10, caractérisé par le fait que pour l'enrobage on utilise au moins partiellement une matière plastique transparente à la lumière laser, et qu'après l'enrobage, le réseau est ajusté à l'aide d'un laser.

12. Procédé selon la revendication 9, caractérisé par le fait que la feuille du réseau est rabattue autour de la feuille de support et elle est soudée, sur ses deux côtés, à la feuille de support.

13. Procédé selon l'une des revendications 9 à 12, caractérisé par le fait que sur la feuille de support on conforme, sur les deux côtés, des fiches, que le réseau est plié et que les fiches sont repliées suivant des directions parallèles entre elles.

FIG 1

FIG 2